# FASCICULE DE BREVET EUROPEEN

(11) **EP 0 478 449 B1**
(45) Date de publication et mention de la délivrance du brevet: **14.05.1997**
(21) Numéro de dépôt: 91402549.9
(22) Date de dépôt: 25.09.1991
(51) Int. Cl.: H01L 39/24

(54) **Encre sérigraphiable supraconductrice et procédé de fabrication d'une couche épaisse supraconductrice utilisant cette encre**
Siebdrucktinte und Verfahren zur Herstellung einer supraleitenden Schicht unter Verwendung dieser Tinte
Screen printing ink and method of making a superconducting thick film by using this ink

(30) Priorité: 27.09.1990 FR 9011931
(43) Date de publication de la demande: 01.04.1992
(73) Titulaire: FRANCE TELECOM, 92131 Issy les Moulineaux (FR)
(72) Inventeur: Etrillard, Jackie, F-78130 St Arnould en Yvelines (FR); Morin, Denise, F-94130 Nogent sur Marne (FR)
(74) Mandataire: Dubois-Chabert, Guy

(56) Documents cités:
- EP-A- 0 292 385
- EP-A- 0 376 865
- IEEE TRANSACTION ON MAGNETICS vol. 27, no. 2, Mars 1991, NEW YORK, US pages 1434 - 1437; Button T.W. et al: 'The processing and properties of high Tc thick films' & PROCEEDINGS APPLIED SUPERCONDUCTOR CONFERENCE, 24-28 September 1990, Snowmass, US
- CRYOGENICS vol. 30, no. 7, Juillet 1990, LONDON, UK pages 593 - 598; Uusimäki A. et al: 'Relationship between microstructure and critical parameters in high Tc superconducting B-Pb-Sr-Ca-Cu-O thick films'
- APPLIED PHYSICS LETTERS vol. 55, no. 21, 20 Novembre 1989, NEW YORK, US pages 2236 - 2238; Xu M. et al: 'Highly textured thick films by a melt-annealing technique in the Bi-Sr-Ca-Cu-O system'
- PATENT ABSTRACTS OF JAPAN vol. 14, no. 34 (C-679)23 Janvier 1990 & JP-A-1 270 518

## Description

La présente invention concerne une encre sérigraphiable supraconductrice et un procédé de fabrication d'une couche épaisse supraconductrice utilisant cette encre.

Elle trouve des applications notamment en microélectronique.

Une encre sérigraphiable est une encre qui est apte à être déposée par sérigraphie sur un substrat.

En microélectronique, la technique dite des "couches épaisses" permet de déposer par sérigraphie, suivant un motif souhaité, à travers un masque approprié obtenu par voie photolithographique, une encre qui possède, après cuisson, des propriétés électriques particulières.

C'est ainsi que l'on peut réaliser des circuits hybrides dont les connexions et les composants passifs sont obtenus par sérigraphie.

La mise en évidence des propriétés supraconductrices de certaines céramiques a été rapidement suivie par la mise au point d'encres sérigraphiables à partir de ces céramiques.

De telles encres sont utilisables pour réaliser, par sérigaphie, des connexions supraconductrices de circuits hybrides, connexions qui permettent des commutations plus rapides dans ces circuits et qui diminuent l'importance des problèmes de dissipation thermique dans de tels circuits.

L'encre objet de la présente invention peut aussi s'appliquer à la réalisation de circuits fonctionnant dans le domaine des hyperfréquences, ces circuits comportant des résonateurs à haut coefficient de surtension, résonateurs que l'on peut fabriquer avec des matériaux supraconducteurs.

Une encre sérigraphiable doit satisfaire à trois exigences :
- permettre l'impression sur un substrat,
- conduire à des propriétés électriques déterminées (par exemple supraconductrices), et
- conduire à une adhérence suffisante sur le substrat ainsi qu'à une résistance mécanique et chimique satisfaisante (résistance à l'abrasion, aux rayures, aux vapeurs corrosives ....).

A cet effet, une encre sérigraphiable classique comprend un matériau actif, conduisant aux propriétés électriques requises, une composition organique (qui comprend généralement un liant temporaire et un solvant auxquels on ajoute éventuellement un agent mouillant) et un liant minéral définitif.

La première des trois exigences mentionnées plus haut est satisfaite grâce à la partie organique de l'encre, partie qui comporte généralement, d'une part, une résine ou un polymère (polyméthacrylate ou éthylcellulose par exemple) qui forme un liant temporaire (disparaisant avec la cuisson) et, d'autre part, un solvant peu volatil (le terpinéol par exemple).

Cette partie organique de l'encre a une fonction rhéologique et une fonction thixotropique qui sont spécifiques d'une telle encre.

Ces caractéristiques de l'encre sérigraphiable doivent être aussi stables que possible au cours du temps.

La deuxième exigence est satisfaite en incorporant à la partie organique le matériau actif qui a les propriétés électriques requises ou qui les acquiert après cuisson.

La troisième exigence (adhérence au substrat et résistances mécanique et chimique) est satisfaite en incorporant le liant minéral à la composition organique et au matériau ayant ou étant capable d'acquérir les propriétés électriques requises.

En général, le substrat utilisé est une céramique et, pour réaliser le scellement de ce substrat, on utilise une phase vitreuse fusible (verre pulvérisé après trempe à l'eau) en tant que liant minéral.

Cette phase vitreuse fond lors de la cuisson et conduit au scellement du matériau actif à la céramique.

Au lieu d'utiliser une phase vitreuse fusible en tant que liant minéral, on peut utiliser un liant réactif qui conduit au scellement par réaction chimique avec le substrat.

Il est indispensable que le liant minéral définitif ne modifie pas les caractéristiques électriques du matériau actif utilisé (qui est sous forme de poudre minérale).

En particulier, le liant minéral définitif doit avoir une viscosité, une mouillabilité, une inertie chimique vis-à-vis du matériau actif et un coefficient de dilatation adéquats.

Or, on a constaté que les liants minéraux classiques interagissent de façon destructrice avec les phases supraconductrices.

C'est pourquoi les encres sérigraphiables supraconductrices connues ne comportent aucun liant minéral définitif (destiné à sceller le matériau supraconducteur au substrat à protéger ce matériau contre les rayures et contre un environnement chimiquement agressif.

Ainsi, le document (1) qui, comme les autres documents cités par la suite, est mentionné à la fin de la présente description, décrit la préparation d'une encre sérigraphiable supraconductrice, à base du matériau supraconducteur PbBiSrCaCuO, sans liant minéral définitif.

Une encre sérigraphiable supraconductrice sans liant minéral définitif présente des inconvénients :
- elle ne permet pas de garantir des caractéristiques suffisantes d'adhérence du matériau supraconducteur au substrat sur lequel l'encre est déposée par sérigraphie ; ceci est d'autant plus vrai que l'interaction avec le substrat est l'un des paramètres les plus influents sur la transition supraconductrice du matériau supraconducteur déposé (voir les documents (2) et (3)) et que l'on essaie toujours de minimiser la durée du pallier de température qui permet d'engendrer des liaisons chimiques responsables de l'adhérence ;
- l'absence de liant minéral définitif fait que la couche épaisse formée n'a pas une résistance mécanique suffisante, d'où une friabilité de cette couche qui peut conduire à une dégradation mécanique de celle-ci dans certaines conditions ;
- l'absence de liant minéral définitif conduit également à une faible résistance de la couche épaisse vis-à-vis d'une agression chimique (due à la vapeur d'eau, à des solvants ou à un étamage par exemple) ;
- il est difficile de rendre une encre sérigraphiable sans liant minéral définitif, compatible avec les encres classiques (qui comportent un liant minéral définitif).

La présente invention a pour but de remédier aux inconvénients précédents.

On connaît, par le document EP-A- 0376865, une encre sérigraphiable supraconductrice comprenant avantageusement une composition minérale apte à former un matériau supraconducteur et un liquide comme l'eau ou un alcool.

Elle a pour objet une encre sérigraphiable supraconductrice conformément à la revendication 1.

De préférence, La composition minérale que comporte cette encre comprend une poudre constituée de cristaux du matériau supraconducteur.

Ce matériau supraconducteur peut être un oxyde supraconducteur Bi-Sr-Ca-Cu-O.

Le liant minéral que comporte cette encre peut être sous forme solide ou sous forme organométallique.

On peut par exemple utiliser, en tant que liant minéral, une poudre d'une céramique à base d'oxydes métalliques d'indium et d'étain.

Après dépôt par sérigraphie, cuisson et séchage, cette céramique enrobe les cristaux supraconducteurs formés sans modifier les caractéristiques électriques de ces cristaux.

De plus, cette céramique est compatible avec les encres commercialement disponibles à base d'or et de palladium.

La présente invention concerne également un procédé de fabrication d'une couche épaisse supraconductrice, ce procédé comprenant un dépôt par sérigraphie, sur un substrat, à travers un masque, d'une encre sérigraphiable supraconductrice conforme à l'invention, un séchage puis une cuisson de l'encre déposée.

L'invention sera mieux comprise à la lecture de la description d'exemples de réalisation donnés ci-après à titre purement indicatif et nullement limitatif.

Pour préparer une encre conforme à l'invention on procède par exemple de la manière suivante.

On utilise des pastilles supraconductrices en BiPbSrCaCuO obtenues par des méthodes classiques décrites par ailleurs (voir par exemple document (4)).

Les pastilles sont concassées afin d'obtenir une poudre active fine, constituée de cristaux supraconducteurs.

Après cette opération de concassage, on réalise un double tamisage de la poudre afin d'en éliminer les très petits cristaux, dont la diamètre moyen est inférieur à 5 micromètres, et les cristaux de grande taille, dont la diamètre moyen est supérieur à 50 micromètres.

Dans l'exemple considéré, on peut utiliser en tant que liant minéral une poudre d'oxyde d'indium et d'oxyde d'étain.

On utilise une quantité aussi faible que possible de liant minéral et, de ce fait, la poudre active (constituée de petits cristaux supraconducteurs) est incorporée au liant minéral lui-même préalablement incorporé à la composition organique que doit comporter l'encre.

Cette dernière est un mélange de terpinéol et d'un polyméthacrylate ou d'éthylcellulose.

Au lieu d'utiliser un liant minéral sous forme solide, on peut utiliser un liant minéral sous forme organométallique (qui, lors de la cuisson ultérieure de l'encre déposée par sérigraphie, se décompose pour conduire au scellement souhaité), comprenant par exemple des composés organometalliques d'indium et d'étain.

A titre d'exemple, ce liant minéral sous forme organométallique rentre pour 10% en masse dans la composition de l'encre.

L'utilisation d'un liant minéral sous forme organométallique permet une meilleur "diffusion" de ce liant minéral dans le mélange formé, ce qui conduit à un meilleur enrobage des cristaux supraconducteurs.

Après avoir dispersé ces cristaux supraconducteurs et le liant minéral dans la composition organique au moyen d'un mixeur ou d'un broyeur à boulets, le mélange obtenu est pétri au moyen d'un mélangeur à rouleaux par exemple.

On obtient ainsi une pâte dont les propriétés rhéologiques sont convenables.

On utilise la pâte ainsi obtenue pour former une couche épaisse supraconductrice sur un substrat, par exemple une céramique de MgO.

On procède par sérigraphie, au travers d'un masque comportant une ouverture permettant d'obtenir la forme souhaitée pour la couche.

A titre expérimental, on peut simplement utiliser un écran classique (125 mesh par exemple).

Après sérigraphie, la couche déposée est séchée, pendant 30 minutes à 120°C, puis cuite dans un four classique avec un profil de cuisson possédant une faible vitesse de montée et de descente en température (par exemple 150°C/h) ainsi qu'un pallier de 5 heures.

Pour réaliser des tests de supraconductivité sur la couche épaisse obtenue, celle-ci est sérigraphiée sur des électrodes en or-palladium qui sont réalisées avec une encre commercialement disponible.

En observant la couche obtenue après cuisson au moyen d'un microscope électronique à balayage, on constate que le liant minéral enrobe les microcristaux supraconducteurs de la couche et l'on observe ce liant minéral à la surface des cristaux supraconducteurs plans.

Ce liant minéral ne modifie pas les propriétés du matériau supraconducteur déposé.

Aucun défaut d'adhérence n'est observé après test d'arrachement, contrairement à ce que l'on observe avec les mêmes motifs, réalisés avec une encre comportant les mêmes produits, sauf le liant minéral, dans les mêmes proportions.

Une analyse, par dispersion d'énergie de rayons X (EDX), de la couche épaisse formée, conduit à un spectre comportant, en plus des raies caractéristiques du matériau supraconducteur formé, les raies qui sont dûes au liant minéral utilisé (raies In et Sn).

De plus, la caractérisation électrique de cette couche épaisse met en évidence une transition supraconductrice à 104K (les mesures sont effectuées par la méthode des quatre pointes) avec un courant critique d'environ 100A.cm² , ce qui constitue un progrès sensible par rapport aux encres sans liant minéral (document (1)).

### DOCUMENTS CITES

(1) Superconducting screen printed thick films of YBa₂Cu₃O₇ and Bi_{1.6}Pb_{0.4}Sr_{1.6}Ca_{2.4}Cu₃O₁₀ on polycristalline substrates, T. BROUSSE et al, Appl. Phys. A49, p.217-220 (1989).
(2) Superconductivity and substrate interaction of screen-printed Bi-Sr-Ca-Cu-O films, T. HASHIMOTO et al., Jap. J. of Appl. Phys., vol.27, n°3, mars 1988, p.L384-L386.
(3) High T screen-printed YBa₂Cu₃O₇₋ₓ films : effect of the substrate material, N.P. BANSAL et al., Appl. Phys. Lett. 53(7), 15 Août 1988, p.603.
(4) Formation conditions of the (2223) phase in lead-substituted superconducting ceramics Bi-Sr-Ca-Cu-O, L. PIERRE et al., Solid State Comm., 69, 502 (1989).

## Revendications

1. Encre sérigraphiable supraconductrice comprenant une composition organique, une composition minérale qui forme un matériau supraconducteur ou qui est apte à donner, après cuisson, un matériau supraconducteur, et un liant minéral, encre caractérisée en ce que le liant minéral est chimiquement inerte vis-à-vis du matériau supraconducteur, et est à base d'oxyde d'indium et d'oxyde d'étain.

2. Encre selon la revendication 1, caractérisée en ce que le liant minéral est incorporé à l'encre sous forme de composés organométalliques d'indium et d'étain.

3. Encre selon revendication 1, caractérisée en ce que le liant minéral est une poudre d'oxyde d'indium et d'oxyde d'étain.

4. Encre selon l'une quelconque des revendications 1 à 3, caractérisée en ce que la composition minérale comprend une poudre constituée de cristaux du matériau supraconducteur.

5. Encre selon l'une quelconque des revendications 1 à 4, caractérisée en ce que le matériau supraconducteur est un oxyde supraconducteur Bi-Sr-Ca-Cu-O.

6. Procédé de fabrication d'une couche épaisse supraconductrice, ce procédé comprenant un dépôt par sérigraphie, sur un substrat, à travers un masque, d'une encre sérigraphiable supraconductrice, un séchage puis une cuisson de l'encre déposée, procédé caractérisé en ce que l'encre est conforme à l'une quelconque des revendications 1 à 5.

## Patentansprüche

1. Supraleitende Siebdrucktinte, umfassend eine organische Zusammensetzung, eine mineralische Zusammensetzung, ein supraleitendes Material bildend oder geeignet, nach dem Brennen bzw. Tempern ein supraleitendes Material zu bilden und ein mineralisches Bindemittel, wobei diese Tinte
**dadurch gekennzeichnet** ist, daß das mineralische Bindemittel chemisch inert ist gegenüber dem supraleitenden Material und als Grundmaterial Indiumoxid und Zinnoxid aufweist.

2. Tinte nach Anspruch 1, dadurch gekennzeichnet, daß das mineralische Bindemittel in der Tinte in Form von organischmetallischen Indium- und Zinnverbindungen enthalten ist.

3. Tinte nach Anspruch 1, dadurch gekennzeichnet, daß das mineralische Bindemittel ein Indiumoxid- und Zinnoxidpulver ist.

4. Tinte nach einem der Ansprüche 1 bis 3, dadurch gekennzeichnet, daß die mineralische Zusammensetzung ein Pulver umfaßt, gebildet aus Kristallen des supraleitenden Materials.

5. Tinte nach einem der Ansprüche 1 bis 4, dadurch gekennzeichnet, daß das supraleitende Material ein supraleitendes Bi-Sr-Ca-Cu-O-Oxid ist.

6. Herstellungsverfahren einer supraleitenden Dickschicht, wobei dieses Verfahren das Auftragen einer supraleitenden Siebdrucktinte mittels Siebdruck durch eine Maske auf einem Substrat umfaßt, sodann ein Trocknen und anschließend ein Backen bzw. Tempern der aufgetragenen Tinte, wobei dieses Verfahren dadurch gekennzeichnet ist, daß die Tinte einem der Ansprüche 1 bis 5 entspricht.

## Claims

1. Superconducting screen printing ink incorporating an organic composition, a mineral composition, which forms a superconducting material which is able to give, after baking, a superconducting material and a mineral binder, characterized in that the mineral binder is chemically inert to the superconducting material and is based on indium oxide and tin oxide.

2. Ink according to claim 1, characterized in that the mineral binder is incorporated into the ink in the form of organometallic indium and tin compounds.

3. Ink according to claim 1, characterized in that the mineral binder is an indium oxide and tin oxide powder.

4. Ink according to any one of the claims 1 to 3, characterized in that the mineral composition comprises a powder constituted by crystals of the superconducting material.

5. Ink according to any one of the claims 1 to 4, characterized in that the superconducting material is a superconducting oxide Bi-Sr-Ca-Cu-O.

6. Process for the production of a thick superconducting film, said process incorporating deposition by screen printing on a substrate and through a mask of a superconducting screen printing ink, a drying and then a baking of the deposited ink, characterized in that the ink is in accordance with any one of the claims 1 to 5.
